# EUROPEAN PATENT SPECIFICATION

(11) **EP 0 430 798 B1**
(45) Date of publication and mention of the grant of the patent: **02.04.1997**
(21) Application number: 90403363.6
(22) Date of filing: 27.11.1990
(51) Int. Cl.: H01L 39/22, H01L 39/24

(54) **Tunnel junction device composed of compound oxide superconductor material and method for fabricating the same**
Tunnelübergangseinrichtung aus oxydisch supraleitendem Verbindungsmaterial und Methode zu ihrer Herstellung
Dispositif à jonction à effet tunnel composé de matériau supraconducteur d'oxyde composite et sa méthode de fabrication

(30) Priority: 27.11.1989 JP 307265/89
(43) Date of publication of application: 05.06.1991
(73) Proprietor: SUMITOMO ELECTRIC INDUSTRIES, LTD., Osaka-shi, Osaka 541 (JP)
(72) Inventor: Itozaki, Hideo, c/o Itami Works of, Itami-shi, Hyogo (JP); Tanaka, Saburo, c/o Itami Works of, Itami-shi, Hyogo (JP); Nakanishi, Hidenori, c/o Itami Works of, Itami-shi, Hyogo (JP); Yazu, Shuji, c/o Itami Works of, Itami-shi, Hyogo (JP)
(74) Representative: Phélip, Bruno

(56) References cited:
- EP-A- 0 329 507
- EP-A- 0 342 039
- EP-A- 0 410 373
- EP-A- 0 427 640
- FR-A- 2 469 005
- FR-A- 2 602 246
- APPLIED PHYSICS LETTERS, vol. 55, no. 19, 6th November 1989, pages 2032-2034, New York, US; C.T. ROGERS et al.: "Fabrication of heteroepitaxial YBa2Cu3O7-x- PrBa2Cu3O7-x-YBa2-Cu3O7-x Josehpson devices grown by laser deposition"
- APPLIED PHYSICS LETTERS, vol. 51, no. 3, 20th July 1987, pages 200 - 202

## Description

### Background of the Invention

### Field of the invention

The present invention relates to a tunnel junction device composed of compound oxide superconductor materials, and more specifically to a novel tunnel junction structure effectively used in devices composed of compound oxide superconductor materials and including a tunnel junction, and effectively used for constructing a circuit including a tunnel junction device composed of compound oxide superconductor materials. The present invention also relates to a method for fabricating the above mentioned tunnel junction structure.

### Description of related art

In one field of superconduction application, there has been a technique utilizing a tunnel junction composed of a pair of superconduction layers and a very thin non-superconduction layer sandwiched between the pair of superconduction layers. The tunnel junction represents a non-linear current/voltage characteristics reflecting a superconduction energy gap of the superconduction material. This tunnel junction has been now utilized in sensors such as SQIID and in switching elements such as Josephson devices.

Ordinarily, the tunnel junction used in the above mentioned elements has been formed by stacking on a substrate a first superconduction layer, a non-superconduction layer, and a second superconduction layer in the named order. Each of the first and second superconduction layers can be formed of any superconduction material, and the non-superconduction layer can be formed of any material other than a superconduction material. Therefore, the layer sandwiched between the pair of superconduction layers is called the "non-superconduction layer" as a matter of convenience in this specification. In the case of a superconduction tunnel junction, the non-superconduction layer can be formed of a normal conduction material.

In the above mentioned tunnel junction structure, however, if the non-superconduction material diffuses into the adjacent superconduction layers, the adjacent superconduction layers loses its superconduction characteristics. In addition, in the process of depositing the respective layers of the tunnel junction, if the second superconduction layer is not in matching with the underlying non-superconduction layer, the superconduction characteristics of the second superconduction layer has deteriorated. Furthermore, since the deposition condition becomes unstable at a beginning and an ending of the deposition of each superconduction layer, a boundary region of each superconduction layer often cannot have good characteristics, and therefore, the manufactured tunnel junction device has a deteriorated characteristics.

Under this circumstance, one method has been proposed, in which a non-superconduction layer is formed of a material including the same elements as those of a superconduction layer. For example, if the superconduction layer is formed of YBa₂Cu₃O₇, the non-superconduction layer is formed of a conpound oxide having a composition ratio of Y:Ba:Cu=2:1:1. In the case of forming the non-superconduction layer of the compound oxide including the same elements as those of a superconduction layer, however, the actual deposition operation has become complicated. For example, if the deposition is performed by means of an evaporation process using a target or targets giving, as a whole, a composition corresponding to that of a layer to be deposited, it is necessary to exchange or replace the targets when the non-superconduction layer is deposited after deposition of the first or lower superconduction layer. Furthermore, in order to deposit the second or upper superconduction layer after the deposition of the non-superconduction layer, it is also necessary to exchange or replace the targets, again. Namely, an increased number of deposition steps have been required, and the time required for fabricating has been elongated. In addition, since the deposition process is interrupted or discontinued because of exchange or replacement of the targets, quality of a boundary is inevitably deteriorated.

EP-A-0 329 507 and FR-A-2 469 005 disclose tunnel junction devices wherein an element of the superconductor material is substituted by another element to form the non-superconduction layer.

### Summary of the Invention

Accordingly, it is an object of the present invention to overcome the above mentioned defects of the prior art and to provide a novel method for simply fabricating a tunnel junction device composed of compound oxide superconductor material and having a sharp boundary.

Another object of the present invention is to provide a novel structure for a tunnel junction device composed of compound oxide superconductor material, which has a sharp boundary realized by the fabricating method of the present invention.

According to one aspect of the present invention, there is provided a tunnel junction device as claimed in Claim 1.

According to another aspect of the present invention, there is provided a method of fabricating a tunnel junction device as claimed in Claim 6.

As seen from the above, the tunnel junction device in accordance with the present invention as claimed is characterized in that the first superconductor layer, the non-superconductive material layer, and the second superconductor layer are formed of a single compound oxide having a continuous crystal lattice, and the non-superconductive material layer is realized by doping a dopant into the same compound oxide as that of the superconductor layers.

Compound oxide superconduction material has a particular crystal structure exerting an effective superconduction property, only when the compound oxide superconduction material is deposited in a particular composition ratio under a particular condition. On the other hand, if a dopant is doped into a thin layer of compound oxide having the particular composition ratio, dopant atoms get into a crystal structure, and therefore, only a doped region lose its superconduction property, or has a greatly dropped superconduction critical temperature. Thus, the doped region in which the superconduction property is deteriorated can be used as a non-superconduction layer of a tunnel junction device.

As mentioned hereinbefore, in the conventional tunnel junction device composed of compound oxide superconduction material, the non-superconduction layer is formed to have a composition different from that of the superconduction layer. Therefore, after a first superconduction layer is deposited on a substrate, a target or targets are exchanged or replaced with a second target or a second set of targets, and then, a non-superconduction layer is deposited on the first superconduction layer by using the second target or the second set of targets. Further, after the non-superconduction layer is deposited, the target exchange or replacement is made, and a second superconduction layer is deposited on the non-superconduction layer. Therefore, the conventional process for fabricating the tunnel junction device is complicated, and a sharp boundary is not formed between the non-superconduction layer and each superconduction layer. As a result, it has been difficult to form a tunnel junction device having a desired characteristics.

On the other hand, the tunnel junction device in accordance with the present invention as claimed is formed by continuously depositing the compound oxide superconductor material on a substrate without interrupt of deposition from a beginning of the deposition of the first superconduction layer until a termination of deposition of the second superconduction layers, and adding a dopant concurrently with deposition of the compound oxide superconductor material only during or within the period for forming the non-superconduction layer. Therefore, the deposition of the first superconduction layer, the non-superconduction layer and the second superconduction layer can be continuously carried out under the same condition. As a result, the obtained tunnel junction structure is constituted by a stacked multilayer epitaxially continuously grown as a whole.

The addition of dopant can be carried out by using a cell or evaporation source which has a controllably opened and closed shutter and which contains a target of a dopant, and by opening the shutter only during a period for forming the non-superconduction layer. Therefore, the tunnel junction device can be formed by different deposition processes such as a sputtering, a vacuum evaporation, MBE (molecular beam epitaxy), etc.

The above mentioned tunnel junction device in accordance with the present invention as claimed can be preferably formed by using the following materials:

A preferred substrate on which the above mentioned tunnel junction device is formed, includes a MgO single crystal, a Al₂O₃ single crystal, a LiNbO₃ single crystal, a LiTaO₃ single crystal, and a ZrO₂ single crystal.

The dopant may be any material having a property which causes the doped oxide superconduction material to lose its superconduction without destroying the crystal structure of the oxide superconduction material. For example, the dopant can be selected from doping materials including Ti, Nb, Ta, V and Mo.

The superconductor material used in the tunnel junction device in accordance with the present invention as claimed can be of any known compound oxide superconduction material, for example, a La-Sr-Cu-O type oxide superconduction material, a Y-Ba-Cu-O type oxide superconduction material, a so-called Bi type oxide superconduction material, a so-called Tl type oxide superconduction material, and others.

The thickness of the superconduction layers is preferably on the order of 50 nm to 400 nm (500Å to 4,000Å), and the thickness of the non-superconduction layer is on the order of 1 nm to 20 nm (10Å to 200Å).

The superconductor material used in the tunnel junction device in accordance with the present invention is not limited to the above exemplified compound oxide materials. It should be understood that, if the superconduction characteristics can be controlled by doping, any oxide superconduction material can be used as the superconductor material of the tunnel junction device in accordance with the present invention.

The above and other objects, features and advantages of the present invention will be apparent from the following description of a preferred embodiment of the invention with reference to the accompanying drawings. However, it should be noted that the following disclosure is merely one embodiment for making it easier to understand the present invention, and the present invention is in no way limited to the details of the illustrated structures.

### Brief Description of the Drawings

Figure 1 is a sectional view diagrammatically illustrating a tunnel junction structure in accordance with the present invention; and
Figure 2 is a diagrammatically perspective view of an embodiment of the tunnel junction device in accordance with the present invention.

### Description of the Preferred embodiment

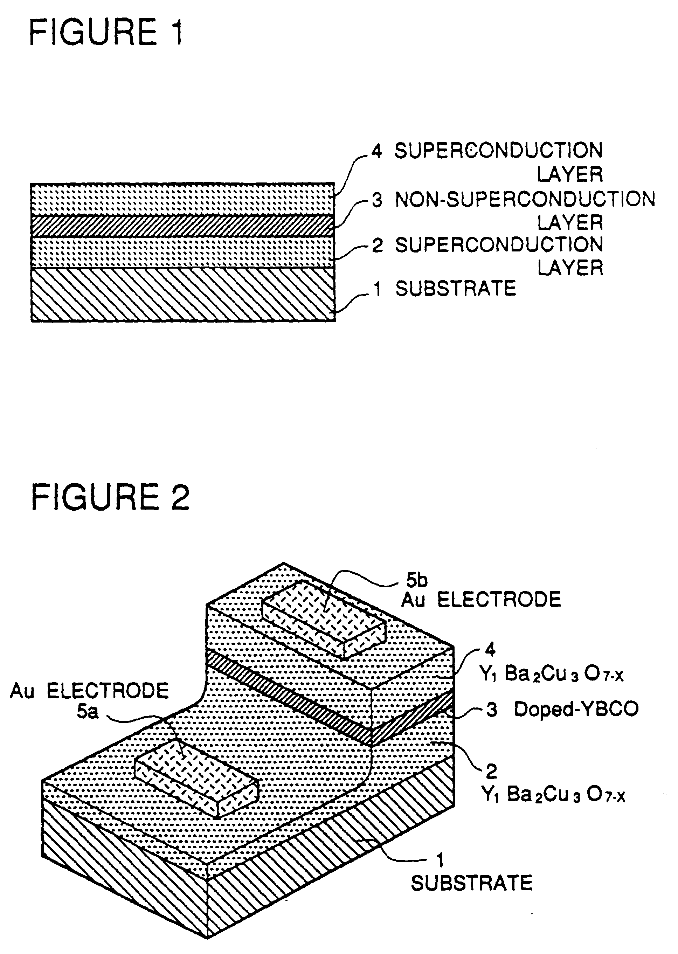

Referring to Figure 1, a tunnel junction structure in accordance with the present invention is diagrammatically illustrated. As shown in Figure 1, the tunnel junction structure is formed of a first superconduction layer 2, a non-superconduction layer 3 and a second superconduction layer 4 stacked in the named order on a substrate 1.

If the tunnel junction structure is realized in the form of a tunnel junction Josephson device, the non-superconduction layer 3 and the superconduction layer 4 are partially cut out so as to expose a portion of the superconduction layer 2, as shown in a diagrammatical perspective view of Figure 2, and a pair of electrodes 5a and 5b are formed on the exposed portion of the superconduction layer 2 and the remaining superconduction layer 4.

For example. each of the superconduction layers 2 and 4 is formed of YBa₂Cu₃O₇, and has a thickness on the order of 200 nm (2000Å). On the other hand, the non-superconduction layer 3 is formed of Y-Ba-Cu-O compound oxide doped with Ti (titanium) and has a thickness on the order of 5 nm (50Å; 10Å = 1nm). The Ti-doped Y-Ba-Cu-O compound oxide loses the superconduction characteristics. Thus, the superconduction layer 2, the non-superconduction layer 3 and the superconduction layer 4 form a so-called SIS Josephson junction structure as a whole.

The tunnel junction device having the structure as mentioned above and composed of Y-Ba-Cu-O type compound oxide superconduction material was fabricated in the following manner, by a simultaneous vacuum evaporation.

Commercially available Y, Ba and Cu were used as an evaporation source, and evaporated by means of K-cells (Knudsen cells). The other deposition condition is as follows:

| | |
|---|---|
| Substrate | {100} plane of MgO single crystal |
| Oxygen partial pressure | 266.64 × 10⁻⁶ Pa (2 × 10⁻⁶ Torr) (1 Torr = 133,32 Pa) |
| Substrate temperature | 620°C |
| Deposition rate | 2nm/minute (20 Å/minute) |

After the deposition of a superconduction material layer was carried out under the above mentioned condition for ten minutes, another K-cell containing Ti was opened while proceeding with the deposition under the same condition, so that Ti is deposited together with Y, Ba and Cu. The evaporation amount of Ti was an amount corresponding to a deposition rate of 0.01 nm/second (0.1Å/second) in the case that only Ti is deposited. This process was carried out for two minutes and thirty seconds. In other words, there was doped the amount of Ti corresponding to a Ti layer of 1.5 nm (15Å) in thickness formed when only Ti is deposited. After the K-cell containing Ti was opened for two minutes and thirty seconds, the shutter of the K-cell containing Ti was closed, and the deposition of Y, Ba and Cu was further proceeded under the above mentioned condition for ten minutes. As a result, a sample A was obtained.

For comparison, by using the same deposition apparatus as that used for forming the sample A, a comparison sample was formed under the same deposition condition. Specifically, after the deposition of Y, Ba and Cu was carried out under the above mentioned condition for ten minutes, the deposition of Y, Ba and Cu was stopped once, and only Ti is evaporated for two minutes and thirty seconds. Thereafter, the evaporation of the Ti is stopped and the deposition of Y, Ba and Cu was carried out again under the above mentioned condition for ten minutes. Thus, a comparison sample B was obtained.

After electrodes were formed for each of the samples A and B, so that each of the samples A and B is brought into the form of a tunnel junction device, a current/voltage characteristics of the SIS junction was measured at a liquid nitrogen temperature (77. 3K).

In the sample A fabricated in accordance with the present invention, a remarkable nonlinearity was found in specific regions of the current/voltage characteristics. However, the sample B showed a substantially linear current/voltage characteristics. In addition, the sample B could never assume a zero voltage condition although it was sufficiently cooled.

As has been described above, the tunnel junction device in accordance with the present invention as claimed is characterized in that a pair of superconduction layers and a non-superconduction layer are formed by continuously epitaxially grown thin layers and the non-superconduction layer is formed by the material having the same crystal structure as that of the superconduction layers and doped with a slight amount of dopant. Therefore, the crystal structure of the superconduction layer is not disturbed at a boundary between the superconduction layer and the non-superconduction layer. In other words, a very sharp boundary is formed between the superconduction layer and the non-superconduction layer. In addition, since the superconduction layers and the non-superconduction layer can be continuously deposited under a constant deposition condition, the tunnel junction device can be effectively fabricated.

The tunnel junction device in accordance with the present invention as claimed can be realized in the form of a discrete tunnel effect element, but also can be assembled within another element or in an integrated circuit, by utilizing a known working process.

The invention has thus been shown and described with reference to the specific embodiment. However, it should be noted that the present invention is in no way limited to the details of the illustrated structures but changes and modifications may be made within the scope of the appended claims.

## Claims

1. A tunnel junction device including a substrate, a first superconduction layer of a compound oxide superconductor material formed on a surface of said substrate, a non-superconduction layer formed on said first superconduction layer, and a second superconduction layer of a compound oxide superconductor material formed on said non-superconduction layer, wherein said non-superconduction material layer is formed of a compound oxide superconductor material which is substantially the same as that of said first and second superconduction layers but which is doped with a dopant, by addition of the dopant, but not by substitution of elements of said superconductor material, of an amount sufficient for the compound oxide superconductor material to lose the superconduction property or to have a greatly dropped superconduction critical temperature, and said first superconduction layer, said non-superconduction layer and said second superconduction layer have a continuous crystal lattice as a whole, said dopant being a metal having a property which causes the doped oxide superconduction material to lose its superconduction without destroying the crystal structure so that said non-superconduction layer is formed by the material having the same crystal structure as that of said first and second superconduction layers, whereby the crystal structure of the superconduction layer is not disturbed at a boundary between the superconduction layer and the non-superconduction layer.

2. A tunnel junction device claimed in claim 1 wherein each of said first and second superconduction layers is formed of a La-Sr-Cu-O type compound oxide superconductor material, a Y-Ba-Cu-O type compound oxide superconductor material, or a compound oxide superconductor material including Bi or T1.

3. A tunnel junction device claimed in claims 1 or 2 wherein the amount of said dopant is an amount in which when only the dopant is deposited, a deposited layer having a thickness of 15.10-¹⁰m (15Å) is formed.

4. A tunnel junction device claimed in claim 3 wherein said dopant is a metal selected from a group consisting of Ti, Nb, Ta, V and Mo.

5. A tunnel junction device claimed in claim 1 wherein said substrate is formed of a material selected from a group consisting of a MgO single crystal, a Al₂O₃ single crystal, a LiNbO₃ single crystal, a LiTaO₃ single crystal, and a ZrO₂ single crystal.

6. A method of fabricating a tunnel junction device including first and second superconduction layers formed of a compound oxide superconductor material and a non-superconduction layer formed between said first and second superconduction layers, comprising the steps of continuously depositing said compound oxide superconductor material on a substrate without interrupt of deposition from a beginning of the deposition of said first superconduction layer until a termination of deposition of said second superconduction layer, and adding, by addition, but not by substitution of elements of said superconductor material, a dopant concurrently with deposition of said compound oxide superconductor material only at the time of forming said non-superconduction layer, so that said first superconduction layer, said non-superconduction layer and said second superconduction layer are continuously formed in the named order without interrupt of deposition of said compound oxide superconductor material, said dopant being a metal having a property which causes the doped oxide superconduction material to lose its superconduction without destroying the crystal structure so that said non-superconduction layer is formed by the material having the same crystal structure as that of said first and second superconduction layers, whereby the crystal structure of the superconduction layer is not disturbed at a boundary between the superconduction layer and the non-superconduction layer, the amount of said dopant being sufficient for the deposited and doped compound oxide superconductor material layer to lose the superconduction property.

7. A method claimed in claim 6 wherein the amount of said dopant is an amount in which when only the dopant is deposited, a deposited layer having a thickness of 15.10-¹⁰m (15Å) is formed.

8. A method claimed in claim 7 wherein said dopant is selected from a group consisting of Ti, Nb, Ta, V and Mo.

9. A method claimed in claim 6 wherein said compound oxide superconductor material is formed of a La-Sr-Cu-O type compound oxide superconductor material, a Y-Ba-Cu-O type compound oxide superconductor material, or a compound oxide superconductor material including Bi or Tl.

10. A method claimed in claim 6 wherein said substrate is formed of a material selected from a group consisting of a MgO single crystal, a Al₂O₃ single crystal, a LiNbO₃ single crystal, a LiTaO₃ single crystal, and a ZrO₂ single crystal.

11. A method claimed in claim 6 wherein said continuous deposition of said compound oxide superconductor material is carried out by means of a vacuum evaporation process using the same target means giving a composition corresponding to that of said first and second superconduction layers.

## Patentansprüche

1. Tunnelübergangseinrichtung, mit einem Substrat, mit einer ersten supraleitenden Schicht aus einem supraleitenden Verbundoxid auf einer Oberfläche des Substrats, mit einer nicht-supraleitenden Schicht auf der ersten supraleitenden Schicht und mit einer zweiten supraleitenden Schicht aus einem supraleitenden Verbundoxid auf der nicht-supraleitenden Schicht, wobei die nicht-supraleitende Schicht aus einem supraleitenden Verbundoxid besteht, welches im wesentlichen das gleiche ist wie dasjenige der ersten und zweiten supraleitenden Schichten, jedoch dotiert ist mit einem Dotierstoff durch Zufügung des Dotierstoffes, nicht jedoch durch Ersetzung von Elementen des supraleitenden Materials, in einer Menge, die ausreicht, daß das supraleitende Verbundoxid seine supraleitende Eigenschaft verliert oder eine stark verringerte supraleitende kritische Temperatur aufweist und wobei die erste supraleitende Schicht, die nicht-supraleitende Schicht und die zweite supraleitende Schicht ein insgesamt kontinuierliches Kristallgitter aufweisen, wobei der Dotierstoff ein Metall ist, mit einer Eigenschaft, welche bewirkt, daß das dotierte oxidische supraleitende Material seine Supraleitfähigkeit verliert, ohne die Kristallstruktur zu zerstören, so daß die nicht-supraleitende Schicht durch das Material gebildet wird, welches die gleiche Kristallstruktur aufweist wie die erste und zweite supraleitende Schicht, wobei die Kristallstruktur der supraleitenden Schicht an einer Grenzfläche zwischen der supraleitenden Schicht und der nicht-supraleitenden Schicht nicht gestört wird.

2. Tunnelübergangseinrichtung. nach Anspruch 1, bei der die ersten und zweiten supraleitenden Schichten aus einem supraleitenden La-Sr-Cu-O-Verbundoxid, einem supraleitenden Y-Ba-Cu-O-Verbundoxid oder einem supraleitenden Verbundoxid, welches Bi oder T1 aufweist, bestehend.

3. Tunnelübergangseinrichtung nach Ansprüchen 1 oder 2, wobei die Menge an Dotierstoff eine Menge ist, bei der, wenn nur der Dotierstoff abgeschieden ist, eine abgeschiedene Schicht mit einer Dicke von 15 x 10⁻¹⁰ m (15Å) gebildet wird.

4. Tunnelübergangseinrichtung nach Anspruch 3, bei der der Dotierstoff ein Metall ist, das ausgewählt ist aus einer Gruppe bestehend aus Ti, Nb, Ta, V und Mo.

5. Tunnelübergangseinrichtung nach Anspruch 1, bei der das Substrat aus einem Material gebildet ist, das ausgewählt ist aus einer Gruppe bestehend aus einem MgO-Einkristall, einem Al₂O₃-Einkristall, einem LiNbO₃-Einkristall, einem LiTaO₃-Einkristall und einem ZrO₂-Einkristall.

6. Verfahren zur Herstellung einer Tunnelübergangseinrichtung mit einer ersten und einer zweiten supraleitenden Schicht bestehend aus einem supraleitenden Verbundoxid und mit einer nicht-supraleitenden Schicht zwischen der ersten und zweiten supraleitenden Schicht, umfassend die Schritte der kontinuierlichen umscheidung des supraleitenden Verbundoxids auf einem Substrat ohne Unterbrechung der Abscheidung, vom Beginn der Abscheidung der ersten supraleitenden schicht bis zur Beendigung der Abscheidung der zweiten supraleitenden Schicht und des Zufügens, jedoch nicht des Ersetzens, von Elementen aus dem supraleitenden Material eines Dotierstoffes zugleich mit der Abscheidung des supraleitenden Verbundoxids ausschließlich zur Zeit der Ausbildung der nicht-supraleitenden Schicht, so daß die erste supraleitende Schicht, die nicht-supraleitende Schicht und die zweite supraleitende Schicht kontinuierlich in dieser Reihenfolge ausgebildet werden ohne Unterbrechung der Abscheidung des supraleitenden Verbundoxids, wobei der Dotierstoff ein Metall ist, mit einer Eigenschaft, welche bewirkt, daß das dotierte supraleitende Oxid seine Supraleitfähigkeit verliert ohne die Kristallstruktur der nicht-supraleitenden Schicht zu zerstören, so daß die nicht-supraleitende Schicht aus einem Material besteht, welches die gleiche Kristallstruktur aufweist, wie diejenige der ersten und zweiten supraleitenden Schicht, wobei die Kristallstruktur der supraleitenden Schicht an der Grenzfläche zwischen der supraleitenden Schicht und der nicht-supraleitenden Schicht nicht gestört wird und wobei die Menge an Dotierstoff ausreicht, damit das abgeschiedene und dotierte supraleitende Verbundoxid seine supraleitende Eigenschaft verliert.

7. Verfahren nach Anspruch 6, bei dem die Menge an Dotierstoff eine derartige Menge ist, daß, wenn ausschließlich der Dotierstoff abgeschieden wird, die abgeschiedene Schicht eine Dicke von 15 x 10⁻¹⁰ m (15Å) aufweist.

8. Verfahren nach Anspruch 7, bei dem der Dotierstoff ausgewählt ist aus einer Gruppe bestehend aus Ti, Nb, Ta, V und Mo.

9. Verfahren nach Anspruch 6, bei dem das supraleitende Verbundoxid aus einem supraleitenden La-Sr-Cu-O-Verbundoxid, einem supraleitenden Y-Ba-Cu-O-Verbundoxid oder einem supraleitenden Verbundoxid, das Bi oder Tl aufweist, besteht.

10. Verfahren nach Anspruch 6, bei dem das Substrat aus einem Material besteht, das ausgewählt ist aus einer Gruppe bestehend aus einem MgO-Einkristall, einem Al₂O₃-Einkristall, einem LiNbO₃-Einkristall, einem LiTaO₃-Einkristall und einem ZrO₂-Einkristall.

11. Verfahren nach Anspruch 6, bei dem die kontinuierliche Abscheidung des supraleitenden Verbundoxids durchgeführt wird mittels eines Vakuumverdampfungsverfahrens unter Verwendung der gleichen Target-Anordnung, die eine Zusammensetzung ermöglicht entsprechend derjenigen der ersten und der zweiten supraleitenden Schicht.

## Revendications

1. Dispositif à jonction à effet tunnel comprenant un substrat, une première couche supraconductrice d'un matériau supraconducteur d'un composé d'oxyde formée sur une surface dudit substrat, une couche non-supraconductrice formée sur ladite première couche supraconductrice et une deuxième couche supraconductrice d'un matériau supraconducteur d'un composé d'oxyde formée sur ladite couche non-supraconductrice, dans lequel ladite couche de matériau non-supraconductrice est formée d'un matériau supraconducteur d'un composé d'oxyde qui est sensiblement identique à celui desdites première et deuxième couches supraconductrices mais qui est dopé avec un dopant, par addition du dopant mais non pas par substitution d'éléments dudit matériau supraconducteur, en une quantité suffisante pour que le matériau supraconducteur, du composé d'oxyde perde la propriété supraconductrice ou présente une température critique supraconductrice fortement abaissée, et ladite première couche supraconductrice, ladite couche non-supraconductrice et ladite deuxième couche supraconductrice présentent un réseau cristallin continu comme un tout, ledit dopant étant un métal ayant une propriété qui fait perdre au matériau supraconducteur d'oxyde dopé sa supraconductivité sans détruire la structure cristalline, si bien que ladite couche non-supraconductrice est formée par le matériau ayant la même structure cristalline que celle desdites première et deuxième couches supraconductrices, de sorte que la structure cristalline de la couche supraconductrice n'est pas perturbée à une limite entre la couche supraconductrice et la couche non-supraconductrice.

2. Dispositif à jonction à effet tunnel selon la revendication 1, dans lequel chacune desdites première et deuxième couches supraconductrices est formée d'un matériau supraconducteur d'un composé d'oxyde de type La-Sr-Cu-O, d'un matériau supraconducteur d'un composé d'oxyde de type Y-Ba-Cu-O, ou d'un matériau supraconducteur d'un composé d'oxyde comprenant Bi ou Tl.

3. Dispositif à jonction à effet tunnel selon la revendication 1 ou 2, dans lequel la quantité dudit dopant est telle que lorsque seulement le dopant est déposé, une couche déposée ayant une épaisseur de 15.10⁻¹⁰ m (15 Å) est formée.

4. Dispositif à jonction à effet tunnel selon la revendication 3 dans lequel ledit dopant est un métal choisi parmi le groupe comprenant Ti, Nb, Ta, V et Mo.

5. Dispositif à jonction à effet tunnel selon la revendication 1, dans lequel ledit substrat est formé d'un matériau choisi parmi le groupe comprenant un monocristal MgO, un monocristal Al₂O₃, un monocristal LiNbO₃, un monocristal LiTaO₃ et un monocristal ZrO₂.

6. Procédé de fabrication d'un dispositif à jonction à effet tunnel comprenant des première et deuxième couches supraconductrices formées d'un matériau supraconducteur d'un composé d'oxyde et une couche non-supraconductrice formée entre lesdites première et deuxième couches supraconductrices, comprenant les étapes consistant à déposer en continu ledit matériau supraconducteur de composé d'oxyde sur un substrat, sans interrompre le dépôt à partir du début du dépôt de ladite première couche supraconductrice jusqu'à la fin du dépôt de ladite deuxième couche supraconductrice et à ajouter, par addition mais non pas par substitution des éléments dudit matériau supraconducteur, un dopant concurremment avec le dépôt dudit matériau supraconducteur du composé d'oxyde seulement au moment de la formation de ladite couche non-supraconductrice, si bien que ladite première couche supraconductrice, ladite couche non-supraconductrice et ladite deuxième couche supraconductrice sont formées en continu dans l'ordre indiqué sans interruption du dépôt dudit matériau supraconducteur du composé d'oxyde, ledit dopant étant un métal ayant une propriété qui provoque la perte de supraconductivité du matériau supraconducteur d'oxyde dopé sans détruire la structure cristalline, si bien que ladite couche non-supraconductrice est formée par le matériau ayant la même structure cristalline que celle desdites première et deuxième couches supraconductrices, de sorte que la structure cristalline de la couche supraconductrice n'est pas perturbée à une limite entre la couche supraconductrice et la couche non-supraconductrice, la quantité dudit dopant étant suffisante pour que le matériau supraconducteur du composé d'oxyde déposé et dopé perde la propriété de supraconductivité.

7. Procédé selon la revendication 6, dans lequel la quantité dudit dopant est telle que lorsque seulement le dopant est déposé, une couche déposée ayant une épaisseur de 15.10⁻¹⁰ m (15 Å) est formée.

8. Procédé selon la revendication 7, dans lequel ledit dopant est choisi parmi le groupe comprenant Ti, Nb, Ta, V et Mo.

9. Procédé selon la revendication 6, dans lequel ledit matériau supraconducteur du composé d'oxyde est formé d'un matériau supraconducteur d'un composé d'oxyde de type La-Sr-Cu-O, d'un matériau supraconducteur d'un composé d'oxyde de type Y-Ba-Cu-O ou d'un matériau supraconducteur d'un composé d'oxyde comprenant Bi ou Tl.

10. Procédé selon la revendication 6, dans lequel ledit substrat est formé d'un matériau choisi parmi le groupe comprenant un monocristal MgO, un monocristal Al₂O₃, un monocristal LiNbO3, un monocristal LiTaO₃, et un monocristal ZrO₂.

11. Procédé selon la revendication 6, dans lequel ledit dépôt continu dudit matériau supraconducteur du composé d'oxyde est mis en oeuvre au moyen d'un procédé d'évaporation sous vide en utilisant les mêmes moyens cible donnant une composition correspondant à celle des première et deuxième couches supraconductrices.
